# EUROPÄISCHE PATENTSCHRIFT

(11) **EP 0 423 513 B1**
(45) Veröffentlichungstag und Bekanntmachung des Hinweises auf die Patenterteilung: **19.07.1995**
(21) Anmeldenummer: 90118431.7
(22) Anmeldetag: 26.09.1990
(51) Int. Cl.: H01L 33/00, H01S 3/085, H01S 3/025

(54) **Verfahren zur Herstellung eines Laserwafers**
Method of producing a laserwafer
Procédé de fabrication d'une plaquette à laser

(30) Priorität: 18.10.1989 DE 3934748
(43) Veröffentlichungstag der Anmeldung: 24.04.1991
(73) Patentinhaber: Alcatel SEL Aktiengesellschaft, D-70435 Stuttgart (DE); ALCATEL N.V., NL-1077 XX Amsterdam (NL)
(72) Erfinder: Dütting, Kaspar, D-7000 Stuttgart 31 (DE); Wünstel, Klaus, Dr., D-7141 Schwieberdingen (DE)
(74) Vertreter: Pechhold, Eberhard, Dipl.-Phys.

(56) Entgegenhaltungen:
- US-A- 4 698 129
- US-A- 4 718 070
- US-A- 4 807 238
- PATENT ABSTRACTS OF JAPAN, Band 13, Nr. 26 (E-706), 20. Januar 1989; & JP-A-63 228 790
- APPLIED PHYSICS LETTERS, Band 48, Nr. 24, Juni 1986, Seiten 1675-1677, NewYork, US; T.H. WINDHORN et al.: "Monolithic GaAs/AlGaAs diode laser/deflector devices for light emission normal to the surface"

## Beschreibung

Die Erfindung betrifft ein Verfahren zur Herstellung eines Laserwafers gemäß dem Oberbegriff des Patentanspruchs 1.

Aus der US-Patentschrift No. 4,718,070 sind Laserwafer bekannt, die dadurch erzeugt wurden, daß in einem Halbleiter-Schichtpaket mit eingebetteten, parallel zu den Schichtebenen emittierenden Lasersystemen durch stufenweises naßchemisches Herausätzen von Halbleitermaterial Vertiefungen geschaffen wurden, die die Gestalt von Gräben haben, deren vom zugehörigen Lasersystem abliegende Wand eindimensional oder zweidimensional gekrümmt ist. Insbesondere die in Fig. 8 wiedergegebene facettenartig gekrümmte Fläche 202 ist in der Lage, das vom Lasersystem emittierte Licht in eine Richtung senkrecht zu den Schichtebenen des Halbleiter-Schichtpaketes umzulenken und dabei zu fokussieren, so daß der ursprünglich divergierende Laserstrahl parallelisiert wird.

Es ist Aufgabe der Erfindung, ein weiteres Verfahren zur Herstellung von senkrecht zu den Schichtebenen eines Halbleiter-Schichtpaktes abstrahlenden Laserwafern anzugeben.

Ein derartiges Verfahren wird durch die Merkmale des Anspruchs 1 beschrieben.

Während beim Stufenätzen den Ätzschritten Heizphasen folgen müssen, in denen die durch das Ätzen erzeugten Stufen durch Materialwanderung geschlichtet werden, lassen sich bei dem in der Erfindung verwendeten Trockenätzverfahren die Facetten in einem Arbeitsgang herausarbeiten. Anschließendes Bedampfen, wie es z.B. bei in den Unteransprüchen 2 und 3 beschriebenen Ausgestaltungen erforderlich ist, läßt sich in derselben Anlage, in der das Trockenätzen stattfindet, durchführen.

Ausgestaltungen des Verfahrens nach der Erfindung sind in den Unteransprüchen 2 bis 5 angegeben:

So sieht Anspruch 2 die Herstellung integrierter Monitordioden zusammen mit den Lasersystemen des Laserwafers vor.

Durch Verspiegelung der Facetten (Gegenstand des Anspruchs 3) wird eine möglichst vollständige Reflexion des erzeugten Laserlichts in eine zu den Schichtebenen des Halbleiters senkrechte Richtung erreicht.

Wird auf der einem Lasersystem gegenüberliegenden Seite einer der Vertiefungen im Schichtpaket eine Monitordiode erzeugt, was gemäß Anspruch 2 gleichzeitig mit der Herstellung des Lasersystems geschehen kann, so muß die Verspiegelung der Facette einen Teil des Laserlichtes durchlassen, was durch eine entsprechend dünne Verspiegelung, z.B. mittels einer Goldschicht, erreicht wird. Zusätzlich muß vor der Verspiegelung die Facettenoberfläche, z.B. durch eine SiO₂-Schicht, gegen die metallische Verspiegelungsschicht isoliert werden, um einen Kurzschluß der aktiven Schichten der Monitordiode durch die elektrisch leitfähige Verspiegelung zu vermeiden.

Die Ansprüche 4 und 5 beziehen sich auf Herstellung der Krümmung der Facettenoberfläche. Letzere kann nach Anspruch 4 Teil einer Paraboloidoberfläche, nach Anspruch 5 Teil einer Ellipsoidoberfläche sein. Wird die Facettenoberfläche so angeordnet, daß die Austrittsfläche des Lasersystems etwa im Brennpunkt des Paraboloids oder einem der Brennpunkte des Ellipsoids liegt, so gibt der Laserwafer bei paraboloidischer Facettenoberfläche etwa parallel gerichtetes Licht, bei ellipsoidischer Facettenoberfläche auf einen Brennpunkt hin konvergierendes Licht ab.

Anhand von 5 Figuren sollen nun ein Ausführungsbeispiel nach dem Stand der Technik, sowie das erfindungsgemäße Verfahren und ein damit hergestellter Laserwafer eingehend beschrieben werden.

Es zeigen:
- Fig. 1a und b: einen eindimensional fokussierenden Laserwafer nach dem Stand der Technik,
- Fig. 2: das Prinzip eines doppelt fokussierenden Laserwafers, wie ihn z.B. das Verfahren nach der Erfindung liefert,
- Fig. 3: einen Halbleiter-Wafer mit Photolackmaske vor der Trockenätzung gemäß dem beanspruchten Verfahren,
- Fig. 4: ein Schema des Trockenätzvorganges gemäß dem beanspruchten Verfahren,
- Fig. 5: Schnitt durch einen Wafer mit Lasersystemen und integrierten Monitordioden gemäß dem beanspruchten Verfahren.

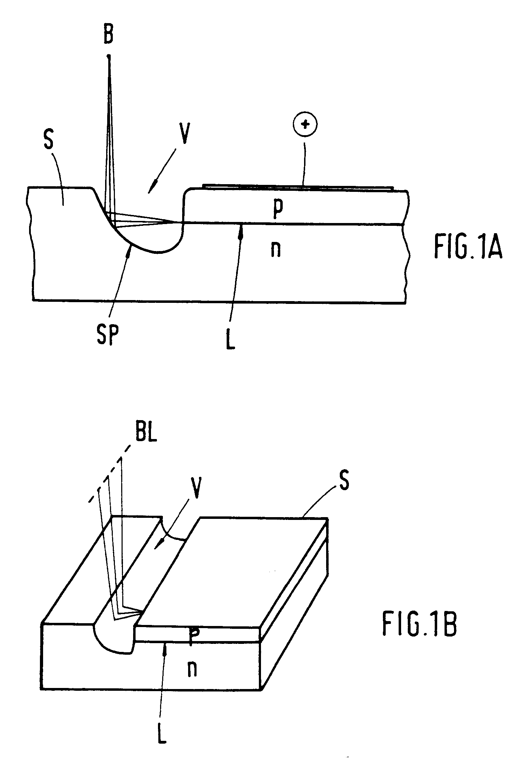

In Fig. 1a ist das Prinzip eines eindimensional fokussierenden Laserwafers nach dem Stand der Technik wiedergegeben. In ein Halbleiter-Schichtpaket (Substrat S), in dem im Bereich der Trennfläche von p-leitendem Halbleitermaterial p und n-leitendem Halbleitermaterial n ein Lasersystem L geschaffen ist, ist eine Vertiefung V eingeätzt, deren laserseitige Wandung im wesentlichen senkrecht ausgebildet ist, und deren vom Lasersystem abliegende Wandung zum Lasersystem hin eindimensional konkav gekrümmt ist und als Hohlspiegel SP wirkt, der den vom Laser ausgehenden divergierenden Lichtstrahl um 90° ablenkt und auf einen Brennpunkt B hin fokussiert.

In Fig. 1b, die das Substrat in räumlicher Sicht wiedergibt, ist erkennbar, daß die Krümmung der vom Lasersystem abliegenden Wandung der Vertiefung V nur in einer Dimension besteht, so daß der in Fig. 1a wiedergegebene, in einer Ebene senkrecht zur Längsachse der Vertiefung erscheinende Brennpunkt B bei Übergang zu räumlicher Betrachtung in eine Brennlinie BL übergeht, eine Fokussierung des Laserlichts in einer Ebene parallel zur Längsachse der Vertiefung V mithin nicht stattfindet.

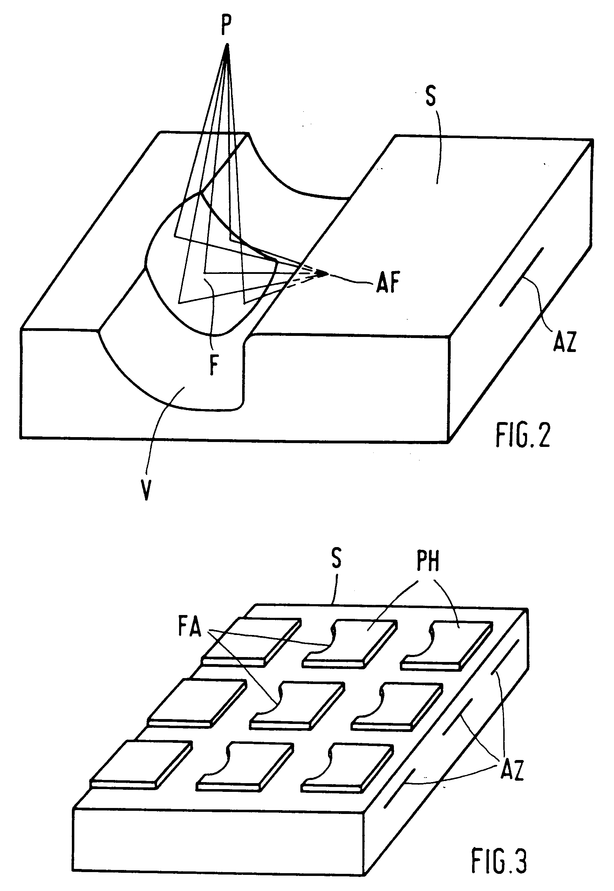

Beim zweidimensional fokussierenden Laserwafer, wie er aus der eingangs genannten US-PS 4,718,070 bekannt ist und wie ihn das Verfahren nach der Erfindung liefert und dessen Prinzip Fig. 2 wiedergibt, ist dagegen jeder Lichtaustrittsfläche AF der in aktiven Zonen AZ des Substrats S geschaffenen Lasersysteme eine zweidimensional gekrümmte Facette F in der dem Lasersystem gegenüberliegenden Wand der Vertiefung V zugeordnet. Das vom Lasersystem divergierend ausgestrahlte Laserlicht wird durch die Oberfläche der Facette F auf einen Brennpunkt P hin fokussiert. Die Brennfläche, durch die das gesamte, von der Oberfläche der Facette reflektierte Licht in der Umgebung des Brennpunkts P tritt, ist im günstigen Falle so klein, daß dort eine nahezu verlustfreie Einkopplung des Laserlichtes in einen Lichtwellenleiter ohne zusätzliche optische Bauelemente möglich ist. Hierzu muß die Facettenoberfläche Teil einer Ellipsoidfläche sein, in deren einem Brennpunkt die Austrittsfläche des Lasers angeordnet ist. Wird anstelle einer Ellipsoidfläche eine Paraboloidfläche geschaffen, so tritt das Laserlicht im wesentlichen parallel aus der Vertiefung V aus.

Um einen derartigen Laserwafer herzustellen, wird ein auf bekannte Art und Weise geschaffenes Substrat S mit in aktiven Zonen AZ angelegten Lasersystemen mit Photolack beschichtet und derart mit entsprechender Chrommaske belichtet, daß die in Fig. 3 wiedergegebene Struktur entsteht. In die einzelnen Laserbereiche abdeckenden Photolackfeldern PH sind Aussparungen FA vorgesehen, die die Krümmungen der später einzuätzenden Facetten in Ebenen parallel zur Längsachse der zwischen den Laserbereichen entstehenden Vertiefungen bestimmen.

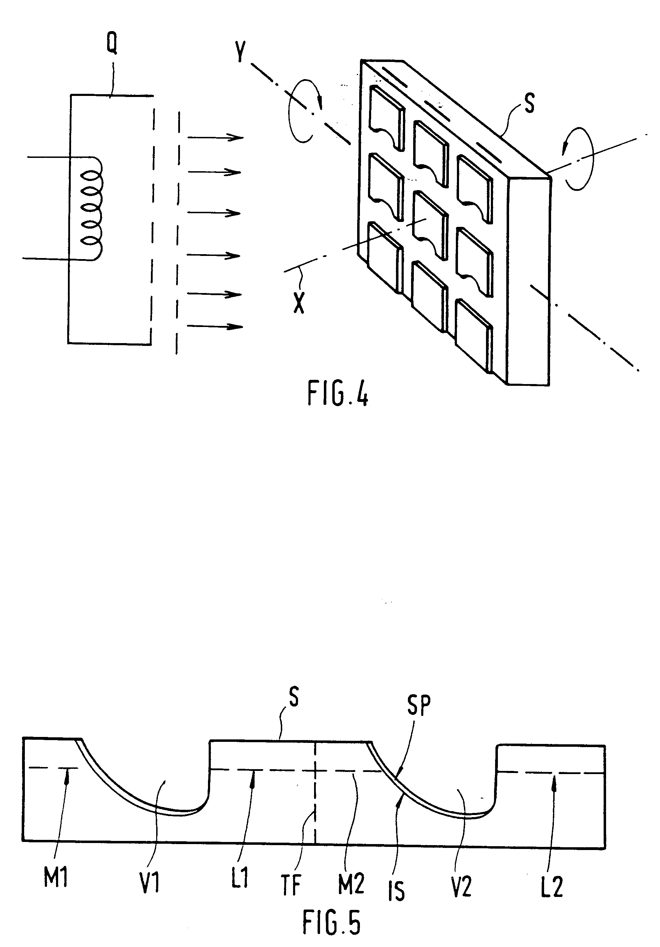

Zum Ätzen der Vertiefungen einschließlich der Facetten wird das mit der Photolackmaske versehene Substrat S in einer Reaktionskammer einem Ionenstrahl ausgesetzt, der aus einer Quelle Q (Fig. 4) stammt und die Substratoberfläche unter variierbarem Einfallswinkel trifft. Das Substrat ist, wie in Fig. 4 dargestellt, z.B. um die Oberflächennormale X drehbar und eine horizontale Achse Y schwenkbar angeordnet. Die Intensität und Zusammensetzung des Ionenstrahls sowie die Verweildauer des Substrates in zur Erzeugung einer gewünschten Facettenkrümmung günstigen Positionen sind während des Trockenätzprozesses ebenfalls variierbar.

Die Verspiegelung der Facettenoberfläche erfolgt im Anschluß an das Ätzen, z.B. in derselben Reaktionskammer. Ist eine der Verspiegelung unterlagerte Isolationsschicht erforderlich, um einen Kurzschluß einer dem Lasersystem gegenüberliegenden Monitordiode durch die Metallschicht des Spiegels zu vermeiden, so läßt sich auch die Isolierschicht (z.B. SiO₂) im selben Reaktionsgefäß aufbringen.

In Fig. 5 ist ein Schnitt durch ein Substrat S, quer zur Längserstreckung der Vertiefungen V1, V2 wiedergegeben. Zwei Lasersysteme L1, L2 mit gegenüberliegenden Monitordioden M1, M2 geben ihr Licht jeweils in Richtung auf die als Facette ausgebildete Wand der zugeordneten Vertiefung aus. Die zweidimensional gekrümmten Facettenoberflächen tragen eine halbdurchlässige Spiegelschicht SP, die von einer Isolierschicht IS unterlagert ist. Entlang der Trennfläche TF wird das Substrat S nach Fertigstellung der Laserwafer gespalten.

## Patentansprüche

1. Verfahren zur Herstellung eines Laserwafers mit mindestens einem in ein Halbleiter-Schichtpaket (Substrat S) eingebetteten, parallel zu den Schichtebenen emittierenden Lasersystem (L, AF, AZ), jeweils einer im Laserstrahl angeordneten, in das Schichtpaket eingeätzten Vertiefung (V), deren zum Lasersystem hin gelegene Wandung größtenteils eben und senkrecht zum Laserstrahl orientiert ist und deren dem Lasersystem gegenüberliegende Wandung zweidimensional konkav gekrümmt ist und eine Facette (F) bildet, die als Hohlspiegel wirkt und den reflektierten Laserstrahl fokussiert und die derart gegen die Laserstrahlrichtung geneigt ist, daß der an der Oberfläche der Wandung reflektierte Teil des Laserlichts im Mittel senkrecht zu den Schichtebenen aus der Vertiefung austritt,
**dadurch gekennzeichnet**, daß nach Aufbau des Halbleiter-Schichtpaketes (Substrat S) mit den in dieses eingebetteten Laser-Systemen (L1, L2) auf der Oberfläche des Schichtpaketes auf bekannte Art und Weise eine Photolackmaske (PH) erzeugt wird, welche an den Stellen, an denen Vertiefungen (V1, V2) in das Schichtpaket eingeätzt werden sollen, Aussparungen (FA) enthält, deren vom jeweiligen Lasersystem abgewandter Rand, entsprechend der Krümmung der in der jeweiligen Vertiefung zu erzeugenden Facette (F), entlang der Oberfläche des Schichtpakets zum jeweiligen Lasersystem hin konkav gekrümmt ist, daß danach das Schichtpaket im Bereich der zu erzeugenden Vertiefungen unter schrägem Ioneneinfall trocken geätzt wird, wobei der Einfallswinkel des Ionenstrahls während des Trockenätzens in zwei aufeinander senkrecht stehenden Ebenen derart variiert wird, daß sich im Bereich der Aussparungen (FA) der Photolackmaske die gewünschten, zweidimensional gekrümmten Facettenoberflächen bilden.

2. Verfahren nach Anspruch 1, dadurch gekennzeichnet, daß beim Aufbau des Halbleiter-Schichtpaketes (Substrat S) mit den in dieses eingebetteten Lasersystemen (L1, L2) Monitordioden (M1, M2) erzeugt werden, die nach Einätzen der Vertiefung in das Schichtpaket, den Lasersystemen gegenüberliegen und die Oberflächen von Hohlspiegeln aufweisen, und daß zur Erzeugung einer Teilverspiegelung der Oberflächen vor dem Aufbringen einer teildurchlässigen Schicht eine elektrisch isolierende Schicht (IS) aufgebracht wird, sofern die teildurchlässige Schicht nicht selbst isolierend ist.

3. Verfahren nach Anspruch 1, dadurch gekennzeichnet, daß die Oberfläche (SP) der dem Lasersystem (L2) gegenüberliegenden Facette verspiegelt wird.

4. Verfahren nach Anspruch 3, dadurch gekennzeichnet, daß die Oberfläche der dem Lasersystem gegenüberliegenden Facette so geätzt wird, daß sie Teil der Oberfläche eines Paraboloids wird, in dessen Brennpunkt die Austrittsfläche (AF) des Lasersystems angeordnet ist.

5. Verfahren nach Anspruch 3, dadurch gekennzeichnet, daß die Oberfläche der dem Lasersystem gegenüberliegenden Facette so geätzt wird, daß sie Teil der Oberfläche eines Ellipsoides wird, in dessen einem Brennpunkt die Austrittfläche (AF) des Lasersystems angeordnet ist.

## Claims

1. Method of producing a laser wafer having at least one laser system (L, AF, AZ) embedded in a semiconductor layer assembly (substrate S) and emitting parallel to the planes of the layers, and having one recess (V) in each case which is disposed in the laser beam and etched into the layer assembly and whose wall situated adjacent to the laser system is largely flat and oriented perpendicularly with respect to the laser beam and whose wall situated opposite the laser system has two-dimensionally concave curvature and forms a facet (F) which acts as a hollow mirror and focuses the reflected laser beam and which is inclined with respect to the direction of the laser beam in such a way that that portion of the laser light which is reflected at the surface of the wall emerges from the recess, on average, perpendicularly with respect to the planes of the layers, characterized in that, after the semiconductor layer assembly (substrate S) with the laser systems (L1, L2) embedded in it has been built up on the surface of the layer assembly, a photoresist mask (PH) is produced in a known way and contains, at those points at which recesses (V1, V2) are to be etched into the layer assembly, cutouts (FA) whose edge remote from the respective laser system is concavely curved with respect to the respective laser system along the surface of the layer assembly in accordance with the curvature of the facet F to be produced in the respective recess, in that the layer assembly is then dry-etched with inclined incidence of ions in the region of the recesses to be produced, the angle of incidence of the ion beam being varied during the dry etching in two mutually perpendicular planes in such a way that the desired, two-dimensionally curved facet surfaces form in the region of the cutouts (FA) in the photoresist mask.

2. Method according to Claim 1, characterized in that, when the semiconductor layer assembly (substrate S) with the laser systems (L1, L2) embedded in it is being built up, monitor diodes (M1, M2) are produced which, after the recess has been etched into the layer assembly, are situated opposite the laser systems and which have hollow-mirror surfaces, and in that, to produce a partial specular coating of the surfaces, an electrically insulating layer (IS) is applied prior to the application of a partially transparent layer if the partially transparent layer is not itself insulating.

3. Method according to Claim 1, characterized in that the surface (SP) of the facet situated opposite the laser system (L2) is specularly coated.

4. Method according to Claim 3, characterized in that the surface of the facet situated opposite the laser system is etched in such a way that it becomes part of the surface of a paraboloid at whose focal point the exit surface (AF) of the laser system is disposed.

5. Method according to Claim 3, characterized in that the surface of the facet situated opposite the laser system is etched in such a way that it becomes part of the surface of an ellipsoid at whose focal point the exit surface (AF) of the laser system is disposed.

## Revendications

1. Procédé de fabrication d'une plaquette à laser comportant au moins un système laser (L, AF, AZ) enrobé dans un paquet de couches semiconductrices (substrat S) et émettant parallèlement aux plans des couches, comportant chaque fois une cavité (V) qui est disposée dans le faisceau laser, qui est obtenue par attaque dans le paquet de couches, dont la paroi située du côté du système laser est, pour la plus grande partie, plane et orientée perpendiculairement au faisceau laser et dont la paroi située en face du système laser présente une courbure concave bidimensionnelle et forme une facette (F) qui agit comme miroir creux et focalise le faisceau laser réfléchi et qui est inclinée, par rapport à la direction du faisceau laser, de façon que la partie de la lumière laser réfléchie sur la surface de la paroi sorte en moyenne de la cavité perpendiculairement aux plans des couches,
caractérisé par le fait qu'après constitution du paquet de couches semiconductrices (substrat S) avec les systèmes laser (L1, L2) enrobés dans ce paquet, on produit, sur la surface du paquet de couches, de façon connue, un masque de vernis photosensible (PH) qui, aux endroits où des cavités (V1, V2) doivent être réalisées par attaque dans le paquet de couches, comporte des évidements (FA) dont le bord situé du côté opposé au système laser présente, le long de la surface du paquet de couches, une courbure concave orientée vers le système laser en question, en correspondance avec la courbure, de la facette à produire dans la cavité en question, par le fait qu'ensuite on attaque à sec le paquet de couches dans la zone des cavités à produire, sous incidence oblique des ions, l'angle d'incidence du faisceau d'ions pouvant, pendant l'attaque à sec, varier dans deux plans perpendiculaires l'un à l'autre de façon que dans la zone des évidements (FA) du masque de vernis photosensible se forment les surfaces désirées des facettes, à courbure bidimensionnelle.

2. Procédé selon la revendication 1, caractérisé par le fait que lors de la constitution du paquet de couches semiconductrices (substrat 5) avec les systèmes laser (L1, L2) enrobés dans ce paquet, on produit des diodes de surveillance (M1, M2) qui, après obtention de la cavité dans le paquet de couches par attaque, se trouvent en face des systèmes laser et présentent les surfaces de miroir creux, et par le fait que pour obtenir une surface réfléchissante partielle par dépôt métallique, avant de déposer une couche partiellement transparente, on dépose une couche électriquement isolante (IS) dans la mesure où la couche partiellement transparente n'est pas elle-même isolante.

3. Procédé selon la revendication 1, caractérisé par le fait que l'on rend réfléchissante la surface (SP) de la facette située en face du système laser (L2).

4. Procédé selon la revendication 3, caractérisé par le fait que l'on attaque la surface de la facette située en face du système laser de façon qu'elle soit une partie de la surface d'un paraboloïde au foyer duquel est disposée la surface de sortie (AF) du système laser.

5. Procédé selon la revendication 3, caractérisé par le fait que l'on attaque la surface de la facette située en face du système laser de façon qu'elle soit une partie de la surface d'un ellipsoïde à l'un des foyers duquel est disposée la surface de sortie (AF) du système laser.
